# EUROPEAN PATENT APPLICATION

(11) **EP 3 042 932 A1**
(43) Date of publication of application: **13.07.2016**
(21) Application number: 14849554.2
(22) Date of filing: 30.09.2014
(51) Int. Cl.: C08L 63/00, C08K 3/36, C08K 5/00, C08K 5/09, H01L 23/29, H01L 23/31, H01L 25/065, H01L 25/07, H01L 25/18

(54) **EPOXY RESIN COMPOSITION FOR USE IN SEALING OF SEMICONDUCTORS, AND SEMICONDUCTOR-PACKAGED STRUCTURE AND METHOD FOR PRODUCING SAME**

(30) Priority: 30.09.2013 JP 2013205074
(71) Applicant: Nagase ChemteX Corporation, Osaka-shi, Osaka 550-8668 (JP)
(72) Inventor: KITAGAWA, Takeyuki, (JP); FUJII, Yasuhito, (JP); KAN, Katsushi, (JP)
(74) Representative: von Bülow & Tamada
(86) International application number: PCT/JP2014/004986
(87) International publication number: WO 2015/045422

(57) **Abstract**

An epoxy resin composition for encapsulation of semiconductors that contains (A) 100 parts by mass of epoxy resin containing 10 mass% to 45 mass% of novolac-type epoxy resin, (B) 50 parts by mass to 150 parts by mass of acid anhydride, (C) 2 parts by mass to 12 parts by mass of curing accelerator, (D) 5 parts by mass to 50 parts by mass of silicone gel or silicone oil; and (E) fused silica of average particle diameter 2 µm to 30 µm. The fused silica (E) is present in an amount that is 80 mass% to 92 mass%. The viscosity at shear rate 2.5 (1/s) at 25°C is not more than 1000 Pa·s.

## Description

### TECHNICAL FIELD

The present invention relates to an epoxy resin composition, and in particular relates to an epoxy resin composition appropriate for use as a chip-on-wafer-type (CoW-type) semiconductor encapsulant.

### BACKGROUND ART

In recent years, as the trend toward reduction in size of electronic equipment has continued, there has been demand for reduction in the thickness and size of semiconductor products as well. There has therefore been interest in a packaging technique, which might be referred to as wafer-level-chip-size packaging, in which a plurality of bare semiconductor chips are packaged and encapsulated while on the semiconductor wafer as it exists before singulation into dice. The laminated structure comprising the semiconductor encapsulant and the semiconductor wafer is thereafter singulated (diced) to obtain chip-level semiconductor products. It is characteristic of such semiconductor products that, because package area is the same size as the bare semiconductor chip, reduction in size is facilitated as compared with ordinary methods in which dicing of the wafer is first carried out and the bare semiconductor chips are then packaged and encapsulated.

Simultaneous with the demand that semiconductor products be of reduced size, there is also demand that they be of high performance. There has therefore been investigation into semiconductor package structures in which bare semiconductor chips are laminated vertically. As examples of methods for carrying out lamination of bare semiconductor chips, the chip-on-chip (CoC) technique in which bare semiconductor chips are successively laminated to each other, the chip-on-wafer (CoW) technique in which non-defective bare semiconductor chips are successively packaged while on the semiconductor wafer substrate, and other such techniques may be cited.

The CoW technique makes use of wafer-level-chip-size packaging technology. In the CoW technique, a plurality of bare semiconductor chips are packaged while on the semiconductor wafer substrate, and a semiconductor encapsulant is used to carry out encapsulation. Dicing of the semiconductor package structure so obtained is thereafter carried out.

In accordance with the CoW technique, the encapsulation carried out using semiconductor encapsulant is performed on the entire semiconductor wafer substrate. For this reason, warping of the semiconductor package structure which occurs following curing of the semiconductor encapsulant but prior to dicing has been a major problem. Because the semiconductor encapsulant contains thermosetting resin, heating is carried out for acceleration of the curing reaction during the operation in which the semiconductor encapsulant is molded. During the cooling operation which follows, because the bare semiconductor chip, the semiconductor encapsulant, and the semiconductor wafer substrate each shrinks in accordance with its respective coefficient of thermal expansion, the change in dimensions will be non-uniform. As a result, warping of the semiconductor package structure occurs.

Because the bare semiconductor chip and the semiconductor wafer substrate are made up of materials such as silicon and sapphire, they experience little change in dimension. But the semiconductor encapsulant is such that when its glass transition temperature is exceeded, its coefficient of thermal expansion rises rapidly, causing it to experience a large change in dimension. An inorganic substance called filler has therefore been blended at 60% - 95% or 80% - 95% in the semiconductor encapsulant to reduce the coefficient of thermal expansion of the semiconductor encapsulant (see Patent Reference Nos. 1 and 2). In addition, silicone rubber and other such rubber components have been blended in the semiconductor encapsulant to reduce post-curing internal stresses in the semiconductor encapsulant and reduce warping of the semiconductor package structure (see Patent Reference No. 3).

### PRIOR ART REFERENCES

### PATENT REFERENCES

Patent Reference No. 1: Japanese Patent Application Publication Kokai No. 2012-209453
Patent Reference No. 2: Japanese Patent Application Publication Kokai No. 2013-10940
Patent Reference No. 3: Japanese Patent Application Publication Kokai No. 2011-195742

### SUMMARY OF INVENTION

### PROBLEM TO BE SOLVED BY INVENTION

As semiconductor encapsulant, epoxy resin is ordinarily employed, alicyclic epoxy resins being employed in particular from the standpoint of their ease of handling. Because alicyclic epoxy resins are of low viscosity, they permit blending of large amounts of filler therewith. While blending of large amounts of filler permits some degree of alleviation of warping of the semiconductor package structure, it is insufficient. If warping of the semiconductor package structure occurs, this will make it difficult to secure the semiconductor package structure with dicing tape during the dicing operation, making it impossible to carry out dicing. Furthermore, if the singulated semiconductor package structures obtained following dicing are themselves warped, this may result in bad connections when the singulated semiconductor package structures are installed in electronic equipment. Furthermore, against the backdrop of the trend toward reduction in cost, there has in recent years been demand for encapsulation of wafer substrates of larger area. For this reason, there is demand for further reduction in the warping of the semiconductor package structure.

Moreover, it has been found that when the CoW technique is used to manufacture semiconductor package structures there is also a tendency for problems to occur during dicing. That is, because of the fact that there is simultaneous dicing of a laminated structure comprising materials of very different hardnesses, i.e., a structure in which soft semiconductor encapsulant and hard semiconductor wafer substrate are laminated together, this may result in delamination of cured semiconductor encapsulant (hereinafter, sometimes referred to simply as cured substance or overmold material) from the semiconductor wafer substrate and/or may result in chipping of the cured substance.

It is an object of the present invention to reduce warping of a semiconductor package structure that has been sealed with overmold material. Moreover, it is an object of the present invention to reduce chipping and delamination of overmold material during dicing. Furthermore, it is an object of the present invention to provide an epoxy resin composition for encapsulation of semiconductors which reduces warping of semiconductor package structures, which rarely experiences delamination or chipping, and which has excellent handling characteristics.

### MEANS FOR SOLVING PROBLEM

That is, one aspect of the present invention relates to an epoxy resin composition for encapsulation of semiconductors that contains (A) 100 parts by mass of epoxy resin containing 10 mass% to 45 mass% of novolac-type epoxy resin; (B) 50 parts by mass to 150 parts by mass of acid anhydride; (C) 2 parts by mass to 12 parts by mass of curing accelerator; (D) 5 parts by mass to 50 parts by mass of silicone gel or silicone oil; and (E) fused silica of average particle diameter 2 µm to 30 µm; wherein the fused silica (E) is present in an amount that is 80 mass% to 92 mass%; and wherein viscosity at shear rate 2.5 (1/s) at 25°C is not more than 1000 Pa·s.

Another aspect of the present invention relates to a semiconductor package structure provided with (a) a semiconductor wafer substrate having a plurality of element mounting regions; (b) a plurality of bare semiconductor chips respectively mounted at the plurality of element mounting regions; and (c) overmold material that covers surfaces of the plurality of bare semiconductor chips and fills spaces between the bare semiconductor chips; wherein the overmold material is a substance resulting from curing of the epoxy resin composition for encapsulation of semiconductors.

Yet another aspect of the present invention relates to a method for manufacturing a semiconductor package structure provided with an operation in which overmold molding is carried out, on a semiconductor wafer substrate having a plurality of element mounting regions at which a plurality of bare semiconductor chips are respectively mounted, so as to cause the epoxy resin composition for encapsulation of semiconductors to cover surfaces of the plurality of bare semiconductor chips and fill spaces between the bare semiconductor chips.

### BENEFIT OF THE INVENTION

The epoxy resin composition of the present invention makes it possible to reduce warping of semiconductor package structures sealed with semiconductor encapsulant as well as chipping of cured semiconductor encapsulant and delamination of cured semiconductor encapsulant during dicing. Furthermore, this epoxy resin composition also has excellent handling characteristics.

While the novel features of the present invention are stated in the claims that are appended hereto, the present invention, with respect to both constitution and content, together with other objects and features of the present application, will be even better understood as a result of the following detailed description which makes reference to the drawings.

### BRIEF DESCRIPTION OF THE DRAWINGS

[FIG. 1] Drawing for describing an exemplary method for manufacturing a semiconductor package structure.
[FIG. 2] Top view showing in schematic fashion an exemplary semiconductor package structure.
[FIG. 3] Photomicrograph (1000 x) of cured substance portion of cross-section of semiconductor package structure obtained at Working Example 2.
[FIG. 4] Photomicrograph (1000 x) of cured substance portion of cross-section of semiconductor package structure obtained at Comparative Example 2.
[FIG. 5] Photomicrograph (1000 x) of vicinity of interface between cured substance and semiconductor wafer substrate in cross-section of semiconductor package structure obtained at Working Example 2.
[FIG. 6] Photomicrograph (1000 x) of vicinity of interface between cured substance and semiconductor wafer substrate in cross-section of semiconductor package structure obtained at Comparative Example 2.

### EMBODIMENTS FOR CARRYING OUT THE INVENTION

An epoxy resin composition for encapsulation of semiconductors in accordance with the present invention contains: (A) 100 parts by mass of epoxy resin containing 10 mass% to 45 mass% of novolac-type epoxy resin; (B) 50 parts by mass to 150 parts by mass of acid anhydride; (C) 2 parts by mass to 12 parts by mass of curing accelerator; (D) 5 parts by mass to 50 parts by mass of silicone gel or silicone oil; and (E) fused silica of average particle diameter 2 µm to 30 µm. Content of fused silica (E) in the epoxy resin composition is 80 mass% to 92 mass%. Viscosity of the epoxy resin composition at 25°C and a shear rate of 2.5 (1/s) is not more than 1000 Pa·s.

At epoxy resin (A), the novolac-type epoxy resin is a resin obtained from epichlorohydrin and novolac-type resin. As novolac-type epoxy resins, phenol-novolac-type epoxy resins, cresol-novolac-type epoxy resins, dicyclopentadiene-novolac-type epoxy resins, biphenyl-novolac-type epoxy resins, and so forth, may, for example, be cited. When a resin composition containing epoxy resin (A) containing the specified amount of novolac-type epoxy resin, the specified amount of acid anhydride (B), curing accelerator (C), silicone gel or silicone oil (D), and fused silica (E) is used as semiconductor encapsulant, it is possible to reduce warping of the sealed semiconductor package structure as well as chipping of the cured semiconductor encapsulant and delamination of the cured semiconductor encapsulant during dicing. In particular, from the standpoint of their ability to deliver large benefit in terms of reduction of the foregoing problems, dicyclopentadiene-novolac-type epoxy resins as indicated by Formula (1), below, and biphenyl-novolac-type epoxy resins as indicated by Formula (2), below, are preferred.

### [CHEMICAL FORMULA 1]

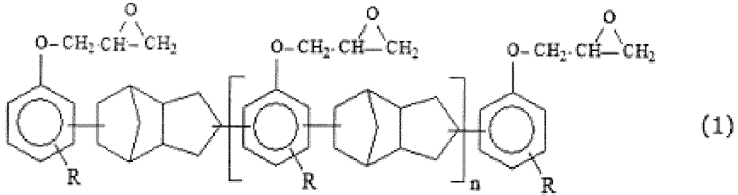

At Formula (1), R indicates a hydrogen atom or an alkyl group having 1 to 6 carbon atoms; n indicates an integer from 0 to 15. There is no limitation with regard to the number(s) or location(s) of alkyl group(s) which may be represented by R. Furthermore, the plurality of R's which appear in the molecule may be the same or different. For example, all of the R's may be hydrogen atoms.

### [CHEMICAL FORMULA 2]

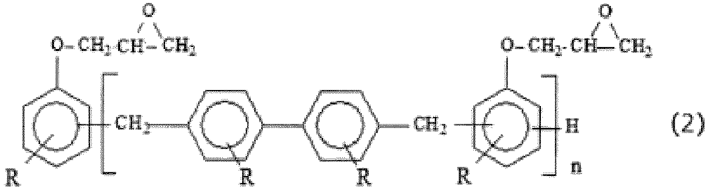

At Formula (2), R indicates a hydrogen atom, a lower alkyl group having 1 to 4 carbon atoms, a phenyl group, or a halogen atom; n indicates an average value which is 1.01 to 5. There is no limitation with regard to the number(s) or location(s) of alkyl group(s), phenyl group(s), or halogen atom(s) which may be represented by R. The plurality of R's which appear in the molecule may be the same or different. For example, all of the R's may be hydrogen atoms.

Note that an epoxy resin having a biphenyl novolac structure as indicated by Formula (2) is commercially available from Nippon Kayaku Co., Ltd. as NC-3000.

The novolac-type epoxy resin is present within epoxy resin (A) in an amount that is 10 mass% to 45 mass%. If the novolac-type epoxy resin is present within epoxy resin (A) in an amount that is less than 10 mass%, warping of the semiconductor package structure sealed by the semiconductor encapsulant will be large, and in addition there will be chipping and delamination of cured substance during dicing. Furthermore, if the novolac-type epoxy resin is present in an amount that is greater than 45 mass%, viscosity of the epoxy resin composition will increase and there will be reduced ease of handling. It is preferred that the novolac-type epoxy resin be present within epoxy resin (A) in an amount that is 25 mass% to 35 mass%.

The cured substance that results from curing of the epoxy resin composition which contains the novolac-type epoxy resin will have reduced tendency to delaminate from the semiconductor wafer substrate as a result of dicing. It is speculated that this is due to an improvement in toughness of the cured substance which is presumably brought about by the novolac-type epoxy resin. Furthermore, the cured substance that results from curing of the epoxy resin composition which contains the novolac-type epoxy resin will have reduced tendency to chip during dicing. It is speculated that this is due to stiffness presumably imparted to the cured substance as a result of the fact that the novolac-type epoxy resin possesses aromatic ring(s).

There is no particular limitation with respect to component(s) other than the novolac-type epoxy resin which may be present in the epoxy resin. For example, bisphenol-A-type epoxy resin, bisphenol-F-type epoxy resin, bisphenol-AD-type epoxy resin, bisphenol-S-type epoxy resin, fluorene-type epoxy resin, naphthalene-type epoxy resin, biphenyl-type epoxy resin, glycidylamine-type epoxy resin, alicyclic-type epoxy resin, dicyclopentadiene-type epoxy resin, polyether-type epoxy resin, silicone-modified epoxy resin, and/or the like may be employed. Any one of these may be used alone, or two or more species chosen from thereamong may be used in combination. Among the foregoing, naphthalene-type epoxy resin, bisphenol-A-type epoxy resin, bisphenol-F-type epoxy resin, bisphenol-AD-type epoxy resin, and biphenyl-type epoxy resin are preferred; bisphenol-A-type epoxy resin, bisphenol-F-type epoxy resin, and naphthalene-type epoxy resin are more preferred; and bisphenol-A-type epoxy resin is, from the standpoint of ease of handling, still more preferred. Two or more species chosen from thereamong may be used in combination.

Acid anhydride (B) is epoxy resin curing agent, there being no particular limitation with respect thereto. For example, phthalic anhydride, hexahydrophthalic anhydride, alkylhexahydrophthalic anhydride, alkyltetrahydrophthalic anhydride, trialkyltetrahydrophthalic anhydride, succinic anhydride, methylnadic anhydride, trimellitic anhydride, pyromettic dianhydride, methylnorbornane-2,3-dicarboxylic acid, and the like may be cited. Any one of these may be used alone, or two or more species chosen from thereamong may be used in combination. In particular, methyltetrahydrophthalic anhydride and methylhexahydrophthalic anhydride are preferred.

Acid anhydride (B) is blended therein in an amount that is 50 parts by mass to 150 parts by mass for every 100 parts by mass of epoxy resin (A). For every 100 parts by mass of epoxy resin (A), if less than 50 parts by mass of acid anhydride (B) is blended therein this will result in reduced curability; if more than 150 parts by mass thereof is blended therein the cured substance will have low strength. It is preferred that acid anhydride (B) be blended therein in an amount that is 80 parts by mass to 120 parts by mass.

There is no particular limitation with respect to what may be used as curing accelerator (C). For example, amine-type curing accelerator, imidazole-type curing accelerator, phosphorous-type curing accelerator, phosphonium-salt-type curing accelerator, bicyclic amidines and derivatives thereof, organometallic complexes, urea compounds of polyamines, and so forth may be cited. It is preferred that the curing accelerator possess latency. As latent curing accelerator, amine-type curing accelerator, imidazole-type curing accelerator, phosphorous-type curing accelerator, and so forth may be cited as examples. Furthermore, as curing accelerator (C), it is preferred that this be used in a form in which it is present as the product (adduct) of reaction with epoxy resin or other such resin.

Curing accelerator (C) is blended therein in an amount that is 2 parts by mass to 12 parts by mass for every 100 parts by mass of epoxy resin (A). For every 100 parts by mass of epoxy resin (A), if less than 2 parts by mass of curing accelerator (C) is blended therein this will prevent the benefit of blending this therein from being sufficiently observed; if more than 12 parts by mass thereof is blended therein this will result in reduced moldability. It is preferred that curing accelerator (C) be blended therein in an amount that is 5 parts by mass to 9 parts by mass. Note that where curing accelerator (C) in the form of adduct is used, the amount of curing accelerator blended therein refers to the net amount of curing accelerator after subtracting components (epoxy resin and/or the like) other than curing accelerator.

Silicone gel or silicone oil (D) has the role of adjusting viscosity of the epoxy resin composition, and it also reduces internal stresses in the cured substance, and reduces warping of the semiconductor package structure that has been sealed with the cured substance. Silicone gel has a polysiloxane structure, and may be manufactured using the condensation reaction method or the addition reaction method. Silicone oil likewise has a polysiloxane structure, having a straight-chain structure in which there are not more than approximately 2000 siloxane bonds. Methods for manufacturing these are known, it being possible to obtain these through use of manufacturing methods described, for example, at Japanese Patent Application Publication Kokai No. S54[1979]-48720, Japanese Patent Application Publication Kokai No. S48[1973]-17847, and so forth. More specifically, these may for example be obtained by reacting SiH-group-containing siloxane with vinyl-group-containing organopolysiloxane at a ratio of 0.3 to 0.8 SiH group for every 1 vinyl group in the presence of platinum-type compound as catalyst. Of these, use of silicone gel is preferred.

Silicone gel or silicone oil (D) is blended therein in an amount that is 5 parts by mass to 50 parts by mass for every 100 parts by mass of epoxy resin (A). For every 100 parts by mass of epoxy resin (A), if less than 5 parts by mass of silicone gel or silicone oil (D) is blended therein this will cause there to be no reduction in warping of the sealed semiconductor package structure; if more than 50 parts by mass thereof is blended therein this will result in reduced ease of handling. It is preferred that silicone gel or silicone oil (D) be blended therein in an amount that is 10 parts by mass to 40 parts by mass.

Furthermore, silicone gel or silicone oil (D) may be such that a dispersant which causes it to be uniformly dispersed throughout the epoxy resin is blended therein. As dispersant, an organopolysiloxane derivative that is a molecule which includes the structure indicated at Formula (3), below, may for example be cited.

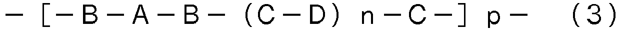

In Formula (3), A indicates an organopolysiloxane compound residue having 20 to 50 siloxane bonds and having an active-hydrogen-containing group at either end thereof. B indicates a residue of a bifunctional organic compound having two functional groups capable of reacting with active hydrogen. More specifically, this indicates a biphenyl- or naphthalene-skeleton-containing epoxy compound residue, a diisocyanate compound residue, or a dicarboxylic acid compound residue. C indicates a residue of a bifunctional organic compound having two active-hydrogen-containing groups. More specifically, this indicates a residue of a bisphenol compound that reacts with an epoxy compound, a residue of a glycol compound that reacts with a diisocyanate compound, or a residue of a diamino compound that reacts with a dicarboxylic acid compound. D indicates a residue of a bifunctional organic compound having two functional groups capable of reacting with active hydrogen. n indicates an integer from 1 to 20; p indicates an integer from 1 to 20. Such an organopolysiloxane derivative will have both an organopolysiloxane chain and an aromatic-ring-containing chain or a long-chain aliphatic chain. It is therefore suitable for use as dispersant to cause the silicone gel or silicone oil to be dispersed throughout the epoxy resin.

As the organopolysiloxane derivative, residue B and residue D in Formula (3) may be the same compound residue, in which case they may have the structure indicated by Formula (4), below.

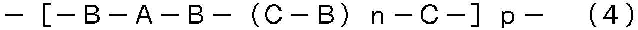

In Formula (4), B is a bifunctional aromatic epoxy compound residue as indicated by Formula (5), below.

### [CHEMICAL FORMULA 3]

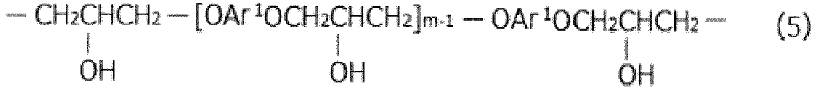

(In the formula, Ar¹ indicates a bivalent aromatic group derived from naphthalene or biphenyl; m indicates the integer 1 or 2.)

In Formula (4), C indicates a bivalent phenol compound residue represented by -O-Ar²-O- (in the formula, Ar² indicates a 2,2-bisphenylpropyl group.).

Methods for manufacturing polysiloxane derivatives are known, it being possible to employ, for example, the method described at Japanese Patent No. 3855074. Furthermore, specific examples of polysiloxane derivatives which may be used as preferred dispersants are disclosed at Working Example 1 (Dispersant B) and Working Example 5 (Dispersant C) of the aforementioned Japanese patent document. As method for manufacture thereof, a method in which bisphenol A diglycidyl ether and bisphenol A are polymerized with the reaction product obtained from reaction of phenol- terminated silicone oil and naphthalene-skeleton-type diglycidyl ether may be cited as an example. This will make it possible to obtain a dispersant having a polyether structure and having a terminal epoxy group.

As the amount of dispersant to be blended therein, it is sufficient that this be an amount necessary to cause silicone gel or silicone oil (D) to be dispersed throughout the resin; for example, when an organopolysiloxane derivative is used as dispersant, it is preferred that 5 parts by mass to 80 parts by mass thereof, and more preferred that 10 parts by mass to 50 parts by mass thereof, be employed for every 100 parts by mass of silicone gel or silicone oil (D).

Fused silica (E) is of average particle diameter 2 µm to 30 µm. An average particle diameter less than 2 µm will result in increased viscosity and reduced ease of handling; an average particle diameter greater than 30 µm will result in reduced moldability. It is preferred that average particle diameter of fused silica (E) be 5 µm to 25 µm. Furthermore, from the standpoint of allowing improvement in handling characteristics, it is more preferred that fused silica (E) contain fused silica of average particle diameter 0.2 µm to 5 µm in an amount that is 5 wt% to 40 wt%. Note that it is preferred that fused silica (E) be spherical and be of high sphericity. Furthermore, the surface thereof may have been made to undergo reaction in advance with a silane coupling agent.

Average particle diameter is particle diameter (D50) at 50% cumulative volume in the particle size volume distribution. Average particle diameter D50 might, for example, be the value measured by the laser diffraction/scattering method using a laser diffraction particle size analyzer.

The epoxy resin composition contains fused silica (E) in an amount that is 80 mass% to 92 mass%. A fused silica (E) content less than 80 mass% will cause there to be no reduction in warping of the sealed semiconductor package structure; a content thereof greater than 92 mass% will cause there to be reduced ease of handling. It is preferred that fused silica (E) content be 83 mass% to 90 mass%.

The epoxy resin composition has a viscosity that is not more than 1000 Pa·s at 25°C and shear rate 2.5 (1/s). In the event that the value of this viscosity varies depending on measurement method, it is the value as measured using an HBT-type viscometer manufactured by Brookfield. If viscosity of the epoxy resin composition at 25°C and shear rate 2.5 (1/s) is greater than 1000 Pa·s, this will increase likelihood of occurrence of incomplete fill and wire sweep during compression molding, and will make it difficult to smoothly supply the resin to the die during molding. It is preferred that viscosity at 25°C and shear rate 2.5 (1/s) be not more than 800 Pa·s.

The various components should be blended at their prescribed proportions, agitation should be carried out for e.g. 60 min to 120 min, and degassing should thereafter be carried out under vacuum before the epoxy resin composition is used. Furthermore, curing may be carried out for on the order of 2 min to 10 min at 50°C to 200°C, or at 100°C to 175°C in particular.

Because the epoxy resin composition has novolac-type epoxy resin that contains aromatic ring(s), the glass transition temperature of the cured substance will be high. For example, the cured substance might have a glass transition temperature of 120°C to 220°C as measured by dynamic viscosity measurement (DMA). For this reason, thermal shrinkage following curing of the epoxy resin composition is small, and it is possible to reduce warping of the semiconductor package structure that has been sealed with the cured substance. Furthermore, because the cured substance has a stiff framework, there will be reduction in chipping of the cured substance during dicing.

The cured substance that results from curing of the epoxy resin composition might, for example, have a storage modulus of 10 GPa to 23 GPa at 25°C as measured by dynamic viscosity measurement (DMA). If the storage modulus is within this range, internal stresses in the cured substance will be comparatively small. It will therefore be possible to reduce warping of the semiconductor package structure that has been sealed with the cured substance.

The epoxy resin composition may contain other additive(s) which have been added thereto. As additive(s), silane coupling agent, carbon black, and so forth may be cited. As silane coupling agent, 3-glycidoxypropyltrimethoxysilane, 3-glycidoxypropyltriethoxysilane, 2-(3,4-epoxycyclohexyl)ethyltrimethoxysilane, 2-(3,4-epoxycyclohexyl)ethyltriethoxysilane, vinyltrimethoxysilane, vinyltriethoxysilane, and/or the like may be employed. Any one of these may be used alone, or two or more species chosen from thereamong may be employed in combination. It is preferred that silane coupling agent be blended therein in an amount that is 0.1 part by mass to 10 parts by mass, and more preferred that this be 1 part by mass to 5 parts by mass, for every 100 parts by mass of epoxy resin. It is preferred that carbon black be blended therein in an amount that is 0.1 part by mass to 10 parts by mass, and more preferred that this be 0.5 part by mass to 3 parts by mass, for every 100 parts by mass of epoxy resin.

Other substances that may, depending on the goal, be employed in suitable amount(s) in the epoxy resin composition of the present invention include antifoaming agent, leveling agent, and pigment.

Because the epoxy resin composition of the present invention undergoes little change in dimension and has appropriate elasticity and viscosity, it is suitable for use as a semiconductor encapsulant for which properties such as moldability, heat-resistance, and resistance to warping are demanded. In particular, it may be advantageously used as semiconductor encapsulant when the overmold molding method is used to carry out encapsulation of wafer-level-chip-size packages, which are large-area semiconductor packages.

As overmold molding, transfer molding, compression molding, and so forth may be cited as examples. Of these, compression molding is preferred. Overmold molding is carried out, preferably at 50°C to 200°C and more preferably at 100°C to 175°C, for 1 min to 15 min. Postcuring may be carried out as necessary for 30 min to 24 hr at 100°C to 200°C.

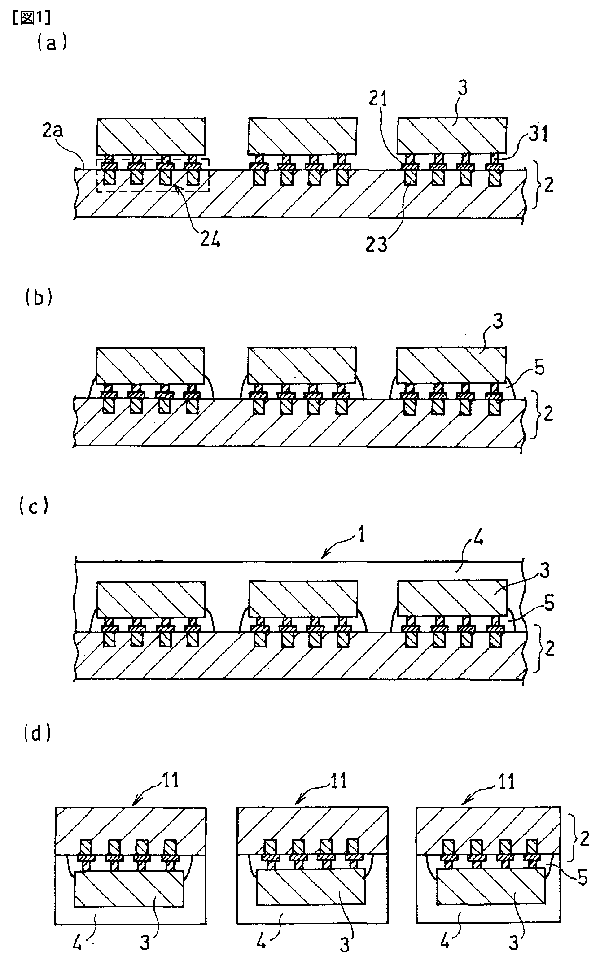

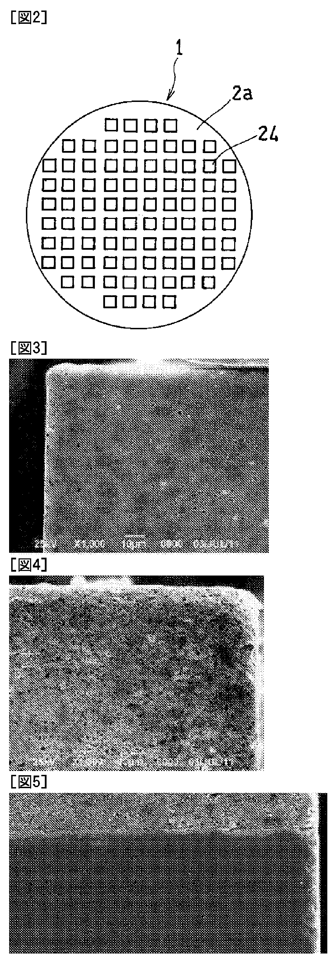

Furthermore, the present invention relates to a semiconductor package structure provided with overmold material which is the cured substance resulting from curing of the epoxy resin composition. Below, the semiconductor package structure is described with reference to (c) and (d) at FIG. 1, and with reference to FIG. 2. Semiconductor package structure 1 is provided with semiconductor wafer substrate 2 having a plurality of element mounting regions 24; a plurality of bare semiconductor chips 3 mounted at plurality of element mounting regions 24; and overmold material 4 which covers the surfaces of plurality of bare semiconductor chips 3 and which fills the spaces between bare semiconductor chips 3. Here, overmold material 4 is the cured substance that results from curing of an epoxy resin composition in accordance with the present invention.

Semiconductor wafer substrate 2 is a wafer substrate on which circuits have been formed in accordance with the usual method, as it exists before being diced into individual semiconductor chips. Semiconductor wafer substrate 2 may be 50 µm to 1000 µm in thickness and may be 8 inches or more in diameter. Even where a semiconductor package structure is formed by encapsulating a semiconductor wafer substrate having such a large area, it will be possible through use of overmold material 4 to markedly reduce the warping thereof. As bare semiconductor chips 3, integrated circuits referred to as ICs and LSIs and the like may be cited.

It is preferred from the standpoint of improvement in connection reliability that semiconductor package structure 1 be provided with underfill material 5 that fills the space between semiconductor wafer substrate 2 and bare semiconductor chips 3. As underfill material 5, while there is no particular limitation, compositions containing epoxy resin, curing agent, curing accelerator, inorganic filler, and/or the like may be cited as examples.

As epoxy resin for use in underfill material 5, while there is no particular limitation, any arbitrary one(s) selected from among the epoxy resins listed for use in the epoxy resin composition of the present invention may be employed. As curing agent and curing accelerator, any arbitrary one(s) selected from among the compounds listed as being for use in the epoxy resin composition of the present invention may be employed. As inorganic filler, besides fused silica, crystalline silica, alumina, magnesium oxide, silicon nitride, and/or the like may be employed.

As shown at (d) in FIG. 1, semiconductor package structure 1 is diced along divisions between element mounting regions 24, the resulting dice being used as singulated semiconductor package structures 11. Because the cured substance that results from curing of the semiconductor encapsulant of the present invention is used as overmold material 4, there will tend to be little occurrence of delamination or chipping of the overmold material 4 at the singulated semiconductor package structures 11 obtained as a result of dicing of semiconductor package structure 1.

Semiconductor package structure 1 may be such that, before being diced along divisions between element mounting regions 24, material is removed from the second surface (not shown; the surface opposite first surface 2a) of semiconductor wafer substrate 2 so that the thickness thereof is reduced and conductors 23 are partly exposed, to permit formation of through-hole conductors (not shown). Moreover, solder balls or other such terminals (not shown) may be formed at ends of through-hole conductors.

The present invention moreover relates to a method of manufacturing a semiconductor package structure through use of what is referred to as the chip-on-wafer technique. That is, the present invention is a method for manufacturing a semiconductor package structure provided with an operation in which overmold molding is carried out, on a semiconductor wafer substrate having a plurality of element mounting regions at which a plurality of bare semiconductor chips are respectively mounted, so as to cause an epoxy resin composition for encapsulation of semiconductors to cover the surfaces of the aforementioned plurality of bare semiconductor chips and fill the spaces between the aforementioned bare semiconductor chips.

Below, a method for manufacturing a semiconductor package structure 1 and a method for manufacturing singulated semiconductor package structures 11 are described with reference to FIG. 1 and FIG. 2. In FIG. 1, (a) through (c) are drawings to assist in describing an exemplary method for manufacturing a semiconductor package structure 1; (a) through (d) at FIG. 1 are drawings to assist in describing an exemplary method for manufacturing singulated semiconductor package structures 11; and FIG. 2 shows exemplary semiconductor package structure 1, being a schematic diagram of the view as seen from the upper surface (first surface 2a) of semiconductor wafer substrate 2.

In FIG. 1, (a) shows a semiconductor wafer substrate 2 on which a plurality of bare semiconductor chips 3 are mounted. More specifically, plurality of bare semiconductor chips 3 are mounted on plurality of element mounting regions 24 at first surface 2a of semiconductor wafer substrate 2 so as make connection with first terminals 21. First terminal 21 is a terminal arranged above conductor 23 such that at least a portion thereof is buried within semiconductor wafer substrate 2. First terminal 21 is electrically connected to element electrode 31 which is arranged at bare semiconductor chip 3. There is no particular limitation as to the material or shape of first terminal 21 and element electrode 31. There likewise being no particular limitation with respect to conductor 23, this may be formed from electrically conductive paste, metallic particles, and other such conductor(s).

Conductor 23 and first terminal 21 may, for example, be formed as follows. Semiconductor wafer substrate 2 might be etched so as to form a plurality of holes at respective element mounting regions 24. Insulating film(s) might be formed on the inner surface of the holes so as to prevent interference between semiconductor wafer substrate 2 and the conductors 23 to be formed therein, and these holes might be filled with conductor(s) 23. These conductors 23 might ultimately, for example, become through-hole conductors that penetrate semiconductor wafer substrate 2. Next, material might be removed from first surface 2a of semiconductor wafer substrate 2 so as to reduce the thickness thereof and expose conductors 23. Finally, electrolytic plating or the like might be used to form pads or other such first terminals 21 over exposed conductors 23.

As shown at (b) in FIG. 1, it is preferred that underfill material 5 fill the spaces between semiconductor wafer substrate 2 and bare semiconductor chips 3. This is so that first terminal 21 which provides continuity between semiconductor wafer 2 substrate and bare semiconductor chip 3 will be protected from external stresses, permitting improvement in connection reliability.

As shown at (c) in FIG. 1, at the semiconductor wafer substrate on which a plurality of bare semiconductor chips are mounted that has been prepared in this way, an epoxy resin composition in accordance with the present invention is used to carry out overmold molding so as to cause the epoxy resin composition to cover the surfaces of the plurality of bare semiconductor chips 3 and fill the spaces between bare semiconductor chips 3. It is preferred that compression molding be carried out. More specifically, an epoxy resin composition which is the material of overmold material 4 might be placed in the lower die of a compression molding device, and semiconductor wafer substrate 2 on which bare semiconductor chips 3 are mounted might be caused to be held by suction to the upper die. As the lower die is then raised, the upper die might be pressed thereagainst, with heat being applied to the epoxy resin composition as molding is carried out. As a result of the heat that has been applied thereto, the epoxy resin composition is cured and becomes overmold material 4.

Moreover, the semiconductor package structure 1 so manufactured may be diced along divisions between element mounting regions 24 to form singulated dice as shown at (d) in FIG. 1. Because the cured substance that results from curing of an epoxy resin composition in accordance with the present invention is used as overmold material 4, the overmold material 4 at the singulated semiconductor package structures 11 obtained as a result of dicing of semiconductor package structure 1 will tend not to delaminate from the semiconductor wafer substrate, and there will tend to be little occurrence of chipping thereat.

Note that before singulation is carried out, material may be removed from the second surface of semiconductor wafer substrate 2 so that the thickness thereof is reduced and conductors 23 are partly exposed, to permit formation of through-hole conductors (not shown). Moreover, solder balls or other such terminals (not shown) may be formed at ends of through-hole conductors.

Next, the present invention is described in more specific terms based on working examples. Note that the following working examples should not be interpreted in such a way as to limit the present invention.

### WORKING EXAMPLES 1 - 5; COMPARATIVE EXAMPLES 1 - 6

The various amounts of the various components were blended as indicated at TABLE 1, and agitation was carried out in thorough fashion at normal temperature (25°C) to obtain a uniform epoxy resin composition. The respective epoxy resin compositions so obtained were compression-molded on a silicon wafer of thickness 300 µm, diameter 12 inches, and on which a plurality of semiconductor chips which each measured 5 mm square, had been mounted, to obtain a semiconductor package structure. Compression molding was carried out at 110°C for 10 min, with postcuring being thereafter carried out at 170°C for 120 min, using a lower die having a cavity of height 0.4 mm and diameter 12 inches.

### EVALUATION

Evaluation was carried out as follows on the epoxy resin compositions at Working Examples 1 to 5 and Comparative Examples 1 to 6 and the cured substances that resulted from curing thereof, as well as the semiconductor package structure sealed by the epoxy resin compositions and the singulated semiconductor package structures that resulted from dicing thereof. Results of evaluation are shown in TABLE 1.

### Viscosity and Handling Characteristics

Viscosity of the epoxy resin composition was measured using an HBT-type viscometer manufactured by Brookfield (spindle type: #29) under conditions 25°C and shear rate 2.5 (1/s). Furthermore, handling characteristics were considered to be good, this being evaluated as O, when viscosity was not more than 1000 Pa·s; above 1000 Pa·s, an evaluation of X was given.

### Glass Transition Temperature Tg of the Cured Substance

The epoxy resin composition was subjected to compression molding at 110°C for 10 min, and postcuring was thereafter carried out at 170°C for 120 min, to obtain the cured substance. The glass transition temperature Tg of the cured substance so obtained was measured using the DMA method. tanδ peak temperature was determined under measurement conditions such that temperature rise rate was 2°C/min and frequency was 1 Hz. A glass transition temperature of 120°C to 220°C was evaluated as ○; outside this range was evaluated as X.

### Storage Modulus of the Cured Substance

DMA was used to determine the storage modulus at 25°C of cured substance obtained in the same fashion as above, with measurement conditions being such that temperature rise rate was 2°C/min and frequency was 1 Hz. A storage modulus of less than 10 GPa was evaluated as X, of 10 GPa to 23 GPa was evaluated as ○, and above 23 GPs was evaluated as X.

### Warping of the Semiconductor Package Structure

The semiconductor package structure was mounted on a laser displacement meter in such fashion that the semiconductor wafer substrate was facing up. Difference in distance at the center and at four points at the periphery was measured, the average of those differences being taken to be the amount of warping. Warping in an amount that was less than 1 mm was evaluated as ○○, in an amount that was 1 mm to 3 mm was evaluated as ○, and in an amount that was above 3 mm was evaluated as X.

### Cross-Sectional Shape Following Dicing

The semiconductor package structure was diced to obtain 10 mm x 10 mm singulated semiconductor package structures. The cross-section of the singulated semiconductor package structure so obtained was viewed under electron photomicrography (1000 x), and the magnitude of the recess was measured. Cross-sections for which a recess of not less than 10 µm was not observed were evaluated as ○; cross-sections for which a recess of not less than 10 µm was observed were evaluated as X. Note that this recess is the depression formed as a result of chipping of resin at the plane of the cut during dicing.

### Delamination Following Dicing

The semiconductor package structure was diced to obtain 10 mm x 10 mm singulated semiconductor package structures. The cross-section of the singulated semiconductor package structure so obtained was viewed under electron photomicrography (1000 x), and visual inspection was used to determine whether or not overmold material had delaminated from the semiconductor wafer substrate. Where delamination was not observed to occur this was evaluated as ○; where delamination did occur this was evaluated as X.

**[TABLE 1]**

| | Ex. 1 | Ex. 2 | Ex. 3 | Ex. 4 | Ex. 5 | Com. Ex. 1 | Com. Ex. 2 | Com. Ex. 3 | Com. Ex. 4 | Com. Ex. 5 | Com. Ex. 6 |
|---|---|---|---|---|---|---|---|---|---|---|---|
| Epoxy Resin (1) | 70 | 70 | 70 | 70 | 70 | 70 | 70 | 70 | 50 | 70 | |
| Epoxy Resin (2) | | | | | | 30 | | | | | |
| Epoxy Resin (3) | | | | | | | 30 | | | | |
| Epoxy Resin (4) | 30 | | | | | | | 30 | | | |
| Epoxy Resin (5) | | 30 | 30 | 30 | 30 | | | | 50 | 30 | 100 |
| Acid anhydride | 100 | 100 | 100 | 100 | 100 | 100 | 100 | 100 | 100 | 100 | 100 |
| Spherical fused silica | 1500 | 1500 | 1500 | 1900 | 1500 | 600 | 2100 | 1500 | 1500 | 800 | 1500 |
| Silane coupling agent | 3 | 3 | 3 | 3 | 3 | 3 | 3 | 3 | 3 | 3 | 3 |
| Carbon black | 1 | 1 | 1 | 1 | 1 | 1 | 1 | 1 | 1 | 1 | 1 |
| Curing accelerator | 6 | 6 | 6 | 6 | 6 | 6 | 6 | 6 | 6 | 6 | 6 |
| Silicone oil | | | | | 10 | | | | | | |
| Silicone gel | 25 | 25 | 35 | 25 | | 25 | 25 | 60 | 25 | 25 | 25 |
| Total | 1735 | 1735 | 1745 | 2135 | 1720 | 835 | 2335 | 1770 | 1735 | 1035 | 1735 |
| Fused silica percentage | 86.5% | 86.5% | 86.0% | 89.0% | 87.2% | 71.9% | 89.9% | 84.7% | 86.5% | 77.3% | 86.5% |
| Viscosity (Pa·s) | 600 | 500 | 600 | 950 | 400 | 400 | 400 | 1200 | 1500 | 100 | Unmeasurable |
| Handling characteristics | ○ | ○ | ○ | ○ | ○ | ○ | ○ | X | X | ○ | X |
| Tg | ○ | ○ | ○ | ○ | ○ | ○ | X | ○ | ○ | ○ | ○ |
| Elastic modulus | ○ | ○ | ○ | ○ | ○ | ○ | ○ | ○ | ○ | X | ○ |
| Warping | ○ | ○ | ○ | ○ | ○ | X | X | ○ | ○ | X | ○ |
| Cross-sectional shape following dicing | ○ | ○○ | ○ | ○ | ○ | X | X | ○ | ○ | X | X |
| Delamination following dicing | ○ | ○ | ○ | ○ | ○ | X | X | ○ | ○ | ○ | X |

Terminology employed at TABLE 1 is as indicated below.
Epoxy Resin (1): RE-310 (manufactured by Nippon Kayaku Co., Ltd.; bisphenol-A-type epoxy resin; epoxy equivalent 184 g/eq)
Epoxy Resin (2): Celloxide 2021 P (manufactured by Daicel Chemical Industries, Ltd.; alicyclic-type epoxy resin; epoxy equivalent 135 g/eq)
Epoxy Resin (3): EP4088S (manufactured by Adeka Corporation; dicyclopentadiene-type epoxy resin; epoxy equivalent 170 g/eq)
Epoxy Resin (4): HP7200 (manufactured by DIC Corporation; dicyclopentadiene-novolac-type epoxy resin; epoxy equivalent 259 g/eq)
Epoxy Resin (5): NC-3000 (manufactured by Nippon Kayaku Co., Ltd.; biphenyl-novolac-type epoxy resin; epoxy equivalent 278 g/eq)
Acid anhydride: Methyltetrahydrophthalic anhydride (manufactured by Hitachi Chemical Company, Ltd.; acid anhydride equivalent 164 g/eq)
Fused silica: Average particle diameter 20 µm
Silicone oil: Epoxy-group-containing silicone oil (epoxy equivalent 1200; 700 Pa·s viscosity at 25°C) Silicone gel: Two-liquid-type silicone gel (TSE3062; manufactured by GE Toshiba Silicones)
Silane coupling agent: 3-glycidoxypropyltrimethoxysilane
Carbon black: #2600 (manufactured by Mitsubishi Chemical Corporation)
Curing accelerator: Amicure PN-23 (amine-adduct-type latent curing accelerator; manufactured by Ajinomoto Co., Inc.)

The epoxy resin compositions at Working Examples 1 through 5 had good handling characteristics, and warping of the semiconductor package structures obtained therewith was small. Furthermore, no delamination or chipping of resin was observed following dicing. FIG. 3 and FIG. 5 show electron photomicrographs of cross-sections of the semiconductor package structures obtained at Working Example 2.

The epoxy resin composition of Comparative Example 1 had satisfactory handling characteristics, but there was a large amount of warping at the semiconductor package structure obtained therewith. It is thought that this may have been due to large change in dimension resulting from high coefficient of thermal expansion at the cured substance caused by use of alicyclic epoxy resin instead of novolac-type epoxy resin. Furthermore, as chipping of resin following dicing was large, it is clear that strength of the cured substance was inadequate. Moreover, delamination of cured substance was observed.

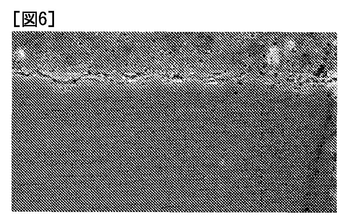

The epoxy resin composition of Comparative Example 2 had satisfactory handling characteristics, but the glass transition temperature of the cured substance was low and there was a large amount of warping at the semiconductor package structure obtained therewith. Furthermore, because strength of the cured substance was inadequate, it was found following dicing that, as shown in FIG. 4, chipping of the cured substance was large, the surface had become severely irregular, and the corners of the cured substance had been removed. Moreover, as shown in FIG. 6, it was found that there was delamination and that cracking had occurred in the vicinity of the interface between the cured substance and the semiconductor wafer substrate.

In the epoxy resin composition of Comparative Example 3, because of the excessive amount of silicone gel that was blended therein, handling characteristics were inferior.

In the epoxy resin composition of Comparative Example 4, because of the high novolac-type epoxy resin content, handling characteristics were inferior.

The epoxy resin composition of Comparative Example 5 had satisfactory handling characteristics, but because of the small amount of fused silica that was blended therein, elasticity of the cured substance was low and there was a large amount of warping at the semiconductor package structure obtained therewith. Furthermore, as chipping of the cured substance following dicing was large, it is clear that strength of the cured substance was inadequate.

At the epoxy resin composition of Comparative Example 6, because the only epoxy resin used was novolac-type epoxy resin, handling characteristics were inferior. Furthermore, following dicing it was found that chipping of the cured substance was large, and in addition that there was delamination at the interface between the cured substance and the semiconductor wafer. It is thought that this occurred due to reduction in toughness as a result of use of only novolac-type epoxy resin.

### INDUSTRIAL UTILITY

An epoxy resin composition in accordance with the present invention may be effectively used as overmold material when, for example, the compression molding method is used to carry out encapsulation of wafer-level-chip-size packages in which large-area semiconductor wafers are employed, in particular.

Although the present invention has been described in terms of embodiments which happen to be preferred at the present time, such disclosure should not be interpreted in limiting fashion. There is no doubt that all manner of variations and improvements will become clear to one of ordinary skill in the art to which the present invention pertains upon reading the foregoing disclosure. The claims which are appended hereto should therefore be interpreted as encompassing all variations and improvements without departing from the true spirit and scope of the present invention.

### EXPLANATION OF REFERENCE NUMERALS

1: semiconductor package structure; 2: semiconductor wafer substrate; 2a: first surface; 21: first terminal; 23: conductor; 24: element mounting region; 3: bare semiconductor chip; 31: element electrode; 4: overmold material; 5: underfill material; 11: singulated semiconductor package structure

## Claims

1. An epoxy resin composition for encapsulation of semiconductors that contains
(A) 100 parts by mass of epoxy resin containing 10 mass% to 45 mass% of novolac-type epoxy resin;
(B) 50 parts by mass to 150 parts by mass of acid anhydride;
(C) 2 parts by mass to 12 parts by mass of curing accelerator;
(D) 5 parts by mass to 50 parts by mass of silicone gel or silicone oil; and
(E) fused silica of average particle diameter 2 µm to 30 µm;
wherein the fused silica (E) is present in an amount that is 80 mass% to 92 mass%; and wherein viscosity at shear rate 2.5 (1/s) at 25°C is not more than 1000 Pa·s.

2. The epoxy resin composition for encapsulation of semiconductors according to claim 1 wherein the novolac-type epoxy resin is at least one species selected from among the group consisting of dicyclopentadiene-novolac-type epoxy resin and biphenyl-novolac-type epoxy resin.

3. The epoxy resin composition for encapsulation of semiconductors according to claim 1 or 2 wherein, as measured by DMA, cured substance glass transition temperature is 120°C to 220°C and storage modulus is 10 GPa to 23 GPa at 25°C.

4. A semiconductor package structure provided with
(a) a semiconductor wafer substrate having a plurality of element mounting regions;
(b) a plurality of bare semiconductor chips respectively mounted at the plurality of element mounting regions; and
(c) overmold material that covers surfaces of the plurality of bare semiconductor chips and fills spaces between the bare semiconductor chips;
wherein the overmold material is a substance resulting from curing of the epoxy resin composition for encapsulation of semiconductors according to any one of claims 1 to 3.

5. A semiconductor package structure according to claim 4 provided with underfill material that fills spaces between the semiconductor wafer substrate and the bare semiconductor chips.

6. A semiconductor package structure according to claim 4 or 5 wherein the semiconductor wafer substrate is 50 µm to 1000 µm in thickness and not less than 8 inches in diameter.

7. A singulated semiconductor package structure obtained by causing the semiconductor package structure according to any one of claims 4 to 6 to be diced along divisions between the element mounting regions.

8. A method for manufacturing a semiconductor package structure provided with an operation in which overmold molding is carried out, on a semiconductor wafer substrate having a plurality of element mounting regions at which a plurality of bare semiconductor chips are respectively mounted, so as to cause the epoxy resin composition for encapsulation of semiconductors according to any one of claims 1 to 3 to cover surfaces of the plurality of bare semiconductor chips and fill spaces between the bare semiconductor chips.

9. The method for manufacturing a semiconductor package structure according to claim 8 wherein the overmold molding is compression molding.

10. The method for manufacturing a semiconductor package structure according to claim 8 or 9 provided with underfill material that fills spaces between the semiconductor wafer substrate and the bare semiconductor chips.

11. A method for manufacturing a singulated semiconductor package structure provided with an operation in which the semiconductor package structure obtained by the manufacturing method described at any one of claims 8 to 10 is subjected to singulation by dicing along divisions between the element mounting regions.
